(19) Europäisches Patentamt
European Patent Office
Office européen des brevets

(11) EP 2 514 851 B1

# (12) EUROPEAN PATENT SPECIFICATION

(45) Date of publication and mention of the grant of the patent:
**15.04.2015 Bulletin 2015/16**

(21) Application number: **10837718.5**

(22) Date of filing: **14.12.2010**

(51) Int Cl.:
*C23C 14/08* (2006.01) *C23C 14/34* (2006.01)
*H01B 5/14* (2006.01) *H01L 31/0224* (2006.01)
*H01L 31/18* (2006.01)

(86) International application number:
**PCT/JP2010/072844**

(87) International publication number:
**WO 2011/074694 (23.06.2011 Gazette 2011/25)**

## (54) TRANSPARENT CONDUCTIVE FILM, SOLAR CELL USING SAME, SPUTTERING TARGET FOR FORMING SAID TRANSPARENT CONDUCTIVE FILM, AND MANUFACTURING METHOD THEREFOR

TRANSPARENTER LEITFÄHIGER FILM, SOLARZELLE DAMIT, SPUTTERTARGET ZUR FORMUNG DIESES TRANSPARENTEN LEITFÄHIGEN FILMS UND HERSTELLUNGSVERFAHREN DAFÜR

FILM CONDUCTEUR TRANSPARENT, CELLULE SOLAIRE L'UTILISANT, CIBLE DE PULVÉRISATION CATHODIQUE POUR FORMER LEDIT FILM CONDUCTEUR TRANSPARENT ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.12.2009 JP 2009284644**
**02.08.2010 JP 2010173691**

(43) Date of publication of application:
**24.10.2012 Bulletin 2012/43**

(73) Proprietor: **Mitsubishi Materials Corporation**
**Chiyoda-ku**
**Tokyo 100-8117 (JP)**

(72) Inventors:
- **ZHANG, Shoubin**
  **Sanda-shi**
  **Hyogo 669-1339 (JP)**
- **MUTSUDA, Yuya**
  **Sanda-shi**
  **Hyogo 669-1339 (JP)**
- **YAMAGUCHI, Gou**
  **Sanda-shi**
  **Hyogo 669-1339 (JP)**
- **KONDOU, Yuichi**
  **Sanda-shi**
  **Hyogo 669-1339 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 025 654**
**EP-A1- 2 053 028**
**WO-A1-2006/129410**
**WO-A1-2007/141994**
**WO-A1-2008/018402**
**JP-A- 8 111 123**
**JP-A- 2009 071 034**

- **QUAN-BAO MA ET AL.: 'Effects of Mg doping on the properties of highly transparent conductive and near infrared reflective Zn1-xMgxO:Ga Films' JOURNAL OF SOLID STATE CHEMISTRY vol. 181, 2008, pages 525 - 529, XP022499597**
- **J.G.LU ET AL.: 'Carrier concentration induced band-gap shift in Al-doped Zn1_xMgxO thin films' APPLIED PHYSICS LETTERS vol. 89, 2006, pages 262107 - 1 - 262107-3, XP012087868**
- **K.MATSUBARA ET AL.: 'Band-gap modified Al-doped Zn1-xMgxO transparent conducting films deposited by pulsed laser deposition' APPLIED PHYSICS LETTERS vol. 85, no. 8, 2004, pages 1374 - 1376, XP012064299**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 514 851 B1

## Description

BACKGROUND OF THE INVENTION

[Field of the Invention]

The present invention relates to a transparent conductive film for use in a liquid-crystal display device, an organic electroluminescent display device, an anti-static conductive film coating, a gas sensor, a solar cell, or the like, a solar cell using the transparent conductive film, a sputtering target for forming the transparent conductive film, and a method for manufacturing the same. In particular, the present invention relates to a transparent conductive film that exhibits excellent moisture resistance for a long period of time when used as a transparent conductive film for a solar cell, and a sputtering target for forming the transparent conductive film.

[Description of the Related Art]

Conventionally, a transparent conductive film composed of an Al-Mg-Zn-based oxide has been known as a type of transparent conductive film for use in a liquid-crystal display device, an electroluminescent display device, an anti-static conductive film coating, a gas sensor, a solar cell, or the like. An exemplary oxide film is disclosed in EP 2025654 A1. In particular, since the band gap of an Al-Mg-Zn-based oxide film represented by $Zn_{1-x}Mg_xO$ doped with Al can be intentionally controlled in a range of from 3.5 to 3.97 eV depending on the amount of Mg added, the Al-Mg-Zn-based oxide film is expected to be applicable as a transparent conductive film for a solar cell or a UV light device.

[Prior Art Documents]

[Patent Documents]

[Patent Document 1] WO 2006/129410
[Non-Patent Document 1] APPLIED PHYSICS LETTERS, Vol. 85, No. 8, p. 1374-1376

SUMMARY OF THE INVENTION

[Problems to be solved by the Invention]

However, since a large amount of MgO serving as an amphoteric oxide is present in the conventional transparent conductive film composed of an Al-Mg-Zn-based oxide, the conventional transparent conductive film exhibits insufficient moisture resistance. Thus, when the conventional transparent conductive film is used as a transparent conductive film for a solar cell, the electrical conductivity of the film is significantly deteriorated for a short period of time due to the presence of moisture and oxygen, resulting in complete loss of the electrical conductivity of the film. Consequently, the power generation efficiency of the solar cell may be significantly decreased. Also, when the conventional transparent conductive film is used as a transparent conductive film for a liquid crystal or an organic EL, the deterioration of the film may cause deterioration of the luminance of a liquid crystal or an organic EL element or the operation failure therefor.

Accordingly, an object of the present invention is to provide a transparent conductive film that does not impair the function as a conductive film in use for a long period of time and is excellent in moisture resistance.

Another object of the present invention is to provide a solar cell using a transparent conductive film exhibiting excellent moisture resistance, which does not decrease the power generation efficiency thereof in use for a long period of time.

Another object of the present invention is to provide a sputtering target that is capable of forming a transparent conductive film exhibiting excellent moisture resistance.

In the sputtering target composed of the conventional Al-Mg-Zn-based oxide disclosed in Patent Document 1, a bulk resistance in the range of $30 \times 10^{-3}$ to $60 \times 10^{-3}\Omega\cdot cm$ is obtained, however, it is desired that higher electrical conductivity be obtained in order to perform stable DC sputtering with higher film-forming rate.

Accordingly, it is an object of the present invention to provide an oxide sputtering target for a transparent conductive film, which exhibits higher electrical conductivity, and a method for manufacturing the same.

[Means to Solve the Problems]

The present inventors have conducted extensive research to improve the moisture resistance of a transparent conductive film composed of the conventional Al-Mg-Zn-based oxide. Consequently, the present inventors have found the following facts:

(A) When a transparent conductive film is constituted by an Al-Mg-Ga-Zn-based oxide which includes a very small amount of Ga, the Al-Mg-Ga-Zn-based oxide transparent conductive film is markedly excellent in moisture resistance as compared with an Al-Mg-Zn-based oxide transparent conductive film. Consequently, an increase in specific resistance due to the presence of moisture and oxygen under the operating environment can be reduced and the deterioration in film characteristics as a transparent conductive film may also be suppressed. Thus, even when the Al-Mg-Ga-Zn-based oxide transparent conductive film is used as a transparent conductive film for a solar cell in use for a long period of time, the reduction in power generation efficiency can be suppressed. Also, when the Al-Mg-Ga-Zn-based oxide transparent conductive film is used as a transparent conductive film for a liquid crystal or an organic EL, the deterioration in element characteristics due to the deterioration of the film can be prevented.
(B) The Al-Mg-Ga-Zn-based oxide transparent conductive film exhibiting excellent moisture resistance can be formed by DC sputtering or pulse DC sputtering of a sputtering target having the same component composition as that of the film.

The present invention has been made on the basis of these findings and adopts the following configurations:

(1) A transparent conductive film composed of an Al-Mg-Ga-Zn-based oxide of which the content ratios of metal component elements are 0.7-7% Al, 9.2-25% Mg, 0.015-0.085% Ga, and the remainder is Zn, by atomic ratio.
(2) A solar cell including a photoelectric conversion layer that generates an electromotive force by means of light irradiation; and positive and negative electrodes that are electrically connected to the photoelectric conversion layer, wherein at least one of the positive and negative electrodes includes the transparent conductive film according to (1).
(3) An oxide sputtering target for forming the transparent conductive film according to (1) or (2) composed of an Al-Mg-Ga-Zn-based oxide of which the content ratios of metal component elements are 0.7-7% Al, 9.2-25% Mg, 0.015-0.085% Ga, and the remainder is Zn, by atomic ratio.

The transparent conductive film composed of an Al-Mg-Ga-Zn-based oxide of the present invention can be formed by DC sputtering or pulse DC sputtering of a target having a predetermined component composition.
The content ratios of metal component elements in an oxide transparent conductive film to be formed need to be 0.7-7% Al, 9.2-25% Mg, 0.015-0.085% Ga, and the remainder Zn, by atomic ratio.
Here, the reason why the content ratios of metal component elements in the transparent conductive film of the present invention are limited as described above is as follows:

Al: Al is added because Al has the effect of improving the electrical conductivity of a transparent conductive film. However, if the Al content is less than 0.7 atomic %, it is not preferable that the electrical conductivity improving effect of Al becomes insufficient, whereas if the Al content exceeds 7 atomic %, it is also not preferable that the transparency of a transparent conductive film is decreased. Thus, the Al content relative to the total amount of the metal component elements included in the transparent conductive film of the present invention is defined in the range of 0.7 to 7 atomic %.
Mg: By containing 9.2 atomic % or greater of Mg as a metal component element in a transparent conductive film, the band gap can be controlled within the range of 3.5 to 3.99 eV depending on the Mg content. However, if the Mg content exceeds 25%, the electrical conductivity of the transparent conductive film is significantly deteriorated due to the presence of moisture and oxygen. Thus, the Mg content relative to the total amount of the metal component elements included in the transparent conductive film of the present invention is defined in the range of 9.2 to 25 atomic %.
Ga: By containing 0.015 atomic % or greater of Ga as a metal component element in a transparent conductive film, deterioration in the electrical conductivity of the transparent conductive film can be suppressed under a high-temperature high-humidity atmospheric environment while maintaining the band gap without impairing the transparency of the transparent conductive film. However, if the Ga content exceeds 0.085%, the electrical conductivity of the film (immediately after film formation, prior to the high-temperature high-humidity test) is deteriorated, resulting in shortage of the electrical conductivity as a function of a transparent conductive film. Thus, the Ga content relative to the total amount of the metal component elements included in the transparent conductive film is defined in the range of 0.015 to 0.085 atomic %.

The Al-Mg-Ga-Zn-based oxide transparent conductive film having the component composition as described above is markedly excellent in moisture resistance as compared with the conventional Al-Mg-Zn-based oxide transparent conductive film. Thus, even when the Al-Mg-Ga-Zn-based oxide transparent conductive film is used as a transparent conductive film for use in a solar cell that includes a photoelectric conversion layer that generates an electromotive force by means of light irradiation and positive and negative electrodes that are electrically connected to the photoelectric conversion layer, wherein at least one of the positive and negative electrodes is constituted by a transparent conductive film, the deterioration in film characteristics and the reduction in power generation efficiency can be suppressed in use for a long period of time.

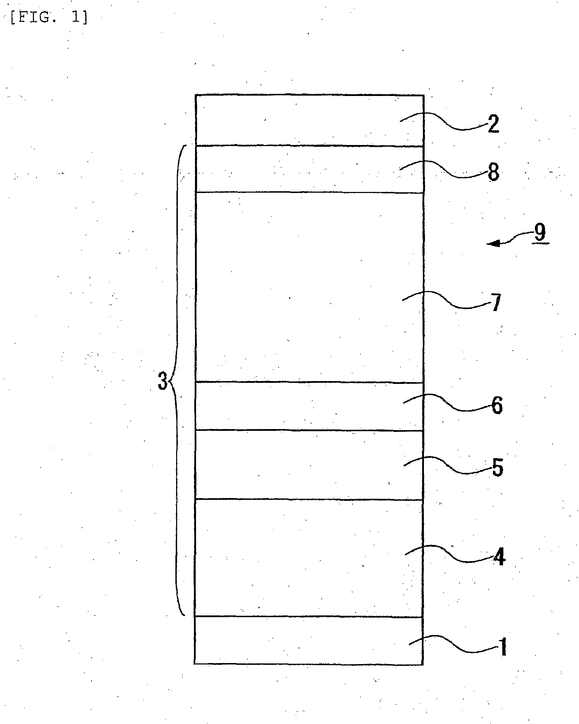

FIG. 1 is a schematic cross-sectional view illustrating an example of a photoelectric conversion cell when the Al-Mg-Ga-Zn-based oxide transparent conductive film of the present invention is used as a transparent conductive film for a solar cell.

In FIG. 1, a photoelectric conversion cell 9 has a structure in which a multilayer power generation layer 3 is formed between a glass substrate (light transmitting substrate) 1 on the light incident side and a backside opaque electrode (backside electrode layer) 2. The power generation layer 3 is formed as a five-layered laminate structure including a first transparent (light-transmissive) conductive film 4, a top cell layer (second photoelectric conversion layer) 5 serving as a photoelectric conversion layer, an intermediate layer 6 serving as a transparent conductive film, a bottom cell layer (first photoelectric conversion layer) 7 serving as a photoelectric conversion layer, and a second transparent conductive film (transparent layer, upper transparent layer) 8.

The first transparent conductive film 4 is joined to the backside of the glass substrate 1. The top cell layer 5 is joined to the backside of the first transparent conductive film 4. The intermediate layer 6 is joined to the backside of the top cell layer 5. The bottom cell layer 7 is joined to the backside of the intermediate layer 6.

The second transparent conductive film 8 is joined to the backside of the bottom cell layer 7.

The backside opaque electrode 2 is joined to the backside of the second transparent conductive film 8.

For components such as a substrate, a film, a layer, or the like, the side on which light is incident is referred to as a "front side", and the side from which light is emitted is referred to as a "backside".

The Al-Mg-Ga-Zn-based oxide transparent conductive film of the present invention may be used for any one of the first transparent conductive film layer, the second transparent conductive film layer, and the transparent conductive intermediate layer. As one embodiment of the photoelectric conversion cell, the bottom cell layer 7 may be c-Si or μc-Si (microcrystalline silicon), the second transparent conductive film 8 may be the Al-Mg-Ga-Zn-based oxide transparent conductive film of the present invention, and the backside opaque electrode 2 may be Ag.

Also, the top cell layer 5 and the bottom cell layer 7 may be formed as the c-Si layer, the μc-Si (microcrystalline silicon) layer, or the a-Si (amorphous silicon) layer.

Furthermore, the photoelectric conversion layer may be formed as a compound semiconductor such as a CIS-based compound layer (a layer consisting of the composition of Cu, In, and Se), a CGIS-based compound layer (a layer to which Ga is further added to a layer consisting of the composition of Cu, In, and Se), or the like, and is not particularly limited.

The photoelectric conversion layer may be configured either by two layers or by one layer as described above and is not particularly limited.

More specifically, the Al-Mg-Ga-Zn-based oxide transparent conductive film can be formed by DC sputtering or pulse DC sputtering of an oxide sputtering target composed of an Al-Mg-Ga-Zn-based oxide of which the content ratios of metal component elements are 0.7-7% Al, 9.2-25% Mg, 0.015-0.085% Ga, and the remainder is Zn, by atomic ratio.

Here, the technical reason why the component composition of sputtering target of the present invention is defined as described above is as follows:

Al: 0.7 atomic % or greater of Al is contained because Al has the effect of improving the carrier density and the hole movement amount of the transparent conductive film obtained by sputtering as well as improving the electrical conductivity of the film. However, if the Al content is less than 0.7 atomic % or if the Al content exceeds 7 atomic %, it is not preferable that the electrical conductivity of the transparent conductive film is decreased. Thus, the Al content contained in a sputtering target for forming the transparent conductive film of the present invention is defined in the range of 0.7 to 7 atomic %.

Mg: Mg is effective for the adjustment of the band gap of the transparent conductive film obtained by sputtering and for the improvement of the transparency with respect to light having a short wavelength and the transparency with respect to light having a near-infrared wavelength. If the Mg content is less than 9.2 atomic %, a sufficient band gap adjustment effect is not obtained, whereas if the Mg content exceeds 25 atomic %, the electrical conductivity of the film is significantly deteriorated.

Thus, the Mg content contained in a sputtering target for forming the transparent conductive film of the present invention is defined in the range of 9.2 to 25 atomic %.

Ga: Ga is effective for the improvement of the moisture resistance of the transparent conductive film. If the Ga content is less than 0.015 atomic %, the improvement of the moisture resistance of the film is insufficient, whereas if the Ga content exceeds 0.085 atomic %, the electrical resistance of the film is significantly increased.

Thus, the Ga content contained in a sputtering target for forming the transparent conductive film of the present invention is defined in the range of 0.015 to 0.085 atomic %.

Since the bulk resistance of an oxide sputtering target composed of an Al-Mg-Ga-Zn-based oxide of which the content ratios of metal component elements are 0.7-7% Al, 9.2-25% Mg, 0.015-0.085% Ga, and the remainder is Zn, by atomic ratio, can be suppressed to 0.1 $\Omega \cdot cm$ or less, a high-quality transparent conductive film can be formed by DC sputtering or pulse DC sputtering with higher film-forming rate.

Although the electrical resistance of a typical Al-doped zinc oxide dense sintered compact (for example, a ZnO sintered compact doped with 2 to 3 wt% of $Al_2O_3$) is in the range of 4 to 8 $\times 10^{-4}$ $\Omega \cdot cm$, the electrical resistance of the Al-Mg-Zn-based oxide target in Examples disclosed in Patent Document 1 is in the range of 30 to 60 $\times 10^{-3}$ $\Omega \cdot cm$, which is nearly hundred times higher than that of the typical Al-doped zinc oxide dense sintered compact. The present inventors have found that one of major causes of deterioration in the electrical conductivity of the Al-Mg-Zn-based oxide target is the decrease in the carrier in the sintered compact due to reaction between $Al_2O_3$ and MgO.

In order to suppress reaction between $Al_2O_3$ and MgO, Patent Document 1 proposes a method for calcinating a powder mixture of $Al_2O_3$ and ZnO, reacting the mixture to some degree, and then sintering the resulting mixture with MgO at high temperatures. However, the calcination temperature must be undesirably high in order to ensure sufficient reaction between $Al_2O_3$ and ZnO. On the other hand, the temperature required for dense sintering increases when the mixture of $Al_2O_3$ and ZnO calcinated at high temperatures is mixed with MgO for principal sintering. When the resulting mixture is sintered at high sintering temperature, the reaction between MgO and $Al_2O_3$ and the reaction between MgO and ZnO become violent, resulting in loss of the electrical conductivity of the sintered compact even if $Al_2O_3$ and ZnO are calcinated.

The present invention adopts the following configuration in order to overcome the aforementioned problems. More specifically, a method for manufacturing the oxide sputtering target of the present invention is characterized in that the method includes the steps of producing a powder mixture by blending an Al oxide, an Mg oxide, a Ga oxide, and a Zn oxide such that the content ratios of metal component elements are 0.7-7% Al, 9.2-25% Mg, 0.015-0.085% Ga, and the remainder is Zn and by milling and mixing the resulting oxides; and heating and sintering the powder mixture while applying a pressure under vacuum or inert gas atmosphere.

Also, the oxide sputtering target of the present invention is characterized in that a volume resistance is 1 $\times 10^{-2}$ $\Omega \cdot cm$ (10 $m\Omega \cdot cm$) or less.

In the method for manufacturing the oxide sputtering target, a powder mixture in which Al oxide, Mg oxide, Ga oxide, and Zn oxide are mixed together according to the aforementioned content ratios is subjected to pressure sintering. Consequently, the diffusion of Al into Zn oxide is promoted by the presence of Ga serving as a diffusion aid, and thus, an Al-Mg-Ga-Zn-based oxide sputtering target may be obtained wherein the electrical conductivity thereof is further improved. More specifically, an Al-Mg-Ga-Zn-based oxide sputtering target having the volume resistance of 1 $\times 10^{-2}$ $\Omega \cdot cm$ or less may be obtained.

According to the result of research conducted by the inventors of the present invention, the diffusion velocity of Ga in ZnO is faster than that of Al in ZnO. As the diffusion of Ga, the substitution of Al ions into $Zn^{2+}$ sites in a ZnO crystal is also activated. Consequently, the sintering is carried out at a relatively low temperature, and thus, a high density sintered compact may be obtained at a temperature lower than that disclosed in Patent Document 1. On the other hand, since the reaction between a Ga ion and MgO is not verified, the reaction between $Al_2O_3$ and MgO and the reaction between MgO and ZnO are not promoted by the addition of Ga. More specifically, the temperature at which $Al_2O_3$ and ZnO are sintered is decreased by the addition of Ga, and thus, a dense sintered compact may be obtained even at a relatively low temperature. As compared with the conventional relatively high sintering temperature, the reaction between $Al_2O_3$ and MgO and the reaction between MgO and ZnO are suppressed, and thus, the electrical conductivity of the sintered compact may be ensured.

Furthermore, the present invention realizes a target having a high density and a high electrical conductivity by lowering a sintering temperature by means of pressure sintering such as hot pressing or the like. More specifically, the densification temperature is lowered by performing pressure sintering, and thus, a high density sintered compact suitable for sputtering is produced at a relatively low sintering temperature to thereby suppress the reaction between $Al_2O_3$ and MgO and the reaction between MgO and ZnO during sintering at high temperatures.

More specifically, the present invention realizes a target having a high density and a high electrical conductivity suitable for sputtering by the simultaneous utilization of the sintering promotion effect and densification temperature reduction effect both obtained by the addition of Ga, and the densification temperature reduction effect obtained by pressure sintering such as hot pressing or the like.

[Effects of the Invention]

According to the present invention, the following effects may be provided.

Since the transparent conductive film of the present invention is constituted by an Al-Mg-Ga-Zn-based oxide in which a very small amount of Ga is included as a metal component, the Al-Mg-Ga-Zn-based oxide transparent conductive film is markedly excellent in moisture resistance as compared with the conventional Al-Mg-Zn-based oxide transparent conductive film. Consequently, an increase in specific resistance due to the presence of moisture and oxygen under the operating environment can be reduced.

Thus, even when the Al-Mg-Ga-Zn-based oxide transparent conductive film is used as a transparent conductive film for a solar cell in use for a long period of time, the reduction in power generation efficiency can be suppressed because the deterioration in film characteristics can be suppressed.

Also, when the Al-Mg-Ga-Zn-based oxide transparent conductive film is used as a transparent conductive film for an organic EL, the reduction in luminous efficiency can be suppressed.

Furthermore, since the Al-Mg-Ga-Zn-based oxide transparent conductive film exhibiting excellent moisture resistance can be readily formed by DC sputtering or pulse DC sputtering of a sputtering target having the same component composition as that of the film with a low bulk resistance, the Al-Mg-Ga-Zn-based oxide transparent conductive film has an excellent industrial effect.

According to the method for manufacturing the oxide sputtering target of the present invention, a powder mixture in which Al oxide, Mg oxide, Ga oxide, and Zn oxide are mixed together according to the aforementioned content ratios is subjected to pressure sintering. Consequently, the diffusion of Al into Zn oxide is promoted by the presence of Ga serving as a diffusion aid, and thus, an Al-Mg-Ga-Zn-based oxide sputtering target may be obtained wherein the electrical conductivity thereof is further improved.

Thus, the oxide sputtering target produced by the manufacturing method of the present invention exhibits high electrical conductivity, which enables stable DC sputtering. Furthermore, a transparent conductive film having excellent transparency and electrical conductivity can be formed.

BRIEF DESCRIPTION OF THE DRAWINGS

FIG. 1 is a schematic cross-sectional view illustrating an example of a photoelectric conversion cell when the Al-Mg-Ga-Zn-based oxide transparent conductive film of the present invention is used as a transparent conductive film for a solar cell.

FIG. 2 is an image illustrating an element distribution map of EPMA for a sintered compact produced in Examples of the oxide sputtering target of the present invention and the manufacturing method therefor.

DESCRIPTION OF THE EMBODIMENTS

Hereinafter, a description will be given of the transparent conductive film of the present invention, a solar cell using the transparent conductive film, a sputtering target for forming the transparent conductive film, and a method for manufacturing the same according to one embodiment of the present invention.

A method for manufacturing an oxide sputtering target for forming the transparent conductive film of the present embodiment includes the steps of producing a powder mixture by blending an Al oxide, an Mg oxide, a Ga oxide, and a Zn oxide such that the content ratios of metal component elements are 0.7-7% Al, 9.2-25% Mg, 0.015-0.085% Ga, and the remainder is Zn, by atomic ratio, and by milling and mixing the resulting oxides; and heating and sintering the powder mixture while applying a pressure under vacuum or inert gas atmosphere.

The sputtering target for forming the transparent conductive film of the present invention can be produced by the following methods.

Firstly, as raw material powders, $Al_2O_3$ powder, MgO powder, $Ga_2O_3$ powder, and ZnO powder having a predetermined purity and a predetermined average particle diameter are weighed and blended together so as to obtain a predetermined composition. The resulting mixture is pulverized by ball milling into particles having an average particle diameter of 0.4 μm or less, is dried in vacuo at a temperature of 80 °C for 5 hours. Then, the dried powder mixture is filled into a graphite mold, and is subjected to vacuum hot-pressing under the condition of a predetermined temperature, a predetermined hour and 350 kgf/cm$^2$ to thereby produce a sputtering target for forming a transparent conductive film.

A detailed description will be given for an example of the manufacturing method. Firstly, as raw material powders, commercially available $Al_2O_3$ powder, MgO powder, $Ga_2O_3$ powder, and ZnO powder having a purity of 99.9% or higher and an average particle diameter of 0.05 to 1 μm are weighed and blended together so as to obtain a predetermined composition. Although a raw material powder having an average particle diameter of less than 0.05 μm exhibits good

sinterability, the density of the pressurized powder compact thereof is low and the contraction rate thereof during sintering is large, resulting in the occurrence of cracks. On the other hand, a raw material powder having an average particle diameter exceeding 1 um exhibits poor sinterability although the density of the pressurized powder compact thereof is high. Thus, a raw material powder having an average particle diameter of 0.05 to 1 μm is preferred in order to obtain a high density sintered compact at a low sintering temperature. These powders are charged to a pot for boll milling together with alcohol as a mixing aid, and are wet-mixed for preferably 24 hours or more using a zirconia ball having a diameter of 5 mm. The resulting powder mixture is dried in vacuo at a temperature of 80 °C for 5 hours.

The produced powder mixture is filled into a graphite mold, and is subjected to hot-pressing in a vacuum at a heating ratio of 10 °C/min, at a maximum temperature of 1000 to 1350 °C, and at a pressure of 150 to 500 kgf/cm$^2$ to thereby produce a sintered compact. The sintered compact is formed into a predetermined shape by machining to thereby produce a sputtering target for forming a transparent conductive film. A method for applying heat and pressure to a sintered compact while passing current therethrough (plasma pressure sintering method) is preferred because the sintering temperature is further decreased and the sintering time is reduced. The thus-produced sputtering target for forming a transparent conductive film is an oxide sputtering target composed of an Al-Mg-Ga-Zn-based oxide of which the content ratios of metal component elements are 0.7-7% Al, 9.2-25% Mg, 0.015-0.085% Ga, and the remainder is Zn, by atomic ratio. The sputtering target for forming a transparent conductive film has a volume resistance of $1 \times 10^{-2}$ Ω·cm or less, that is, has good electrical conductivity of 0.0001 to 0.01 Ω·cm.

The preferred sputtering conditions at the time of sputtering is as follows:

Firstly, the relative density of a sputtering target is preferably 90% or more. If the relative density is less than 90%, the film forming rate is reduced, as well as the film quality of a film to be obtained is deteriorated. The relative density of a sputtering target is more preferably 95% or more, and is particularly preferably 97% or more.

Also, the purity of the aforementioned sputtering target is preferably 99% or more. If the purity of the sputtering target is less than 99%, the electrical conductivity and the chemical stability of a film to be obtained are deteriorated due to the presence of impurities. The purity of the sputtering target is more preferably 99.9% or more, and is particularly preferably 99.99% or more.

Furthermore, when sputtering is performed using the aforementioned sputtering target, it is preferable that a substrate for film formation (hereinafter referred to as "film-forming substrate") and a sputtering target are firstly mounted in a vacuum chamber of a sputtering apparatus to thereby remove moisture absorbed by the apparatus, the film-forming substrate, the sputtering target, or the like.

The removal of moisture can be carried out by vacuum drawing. The vacuum drawing continues, for example, until the degree of vacuum in the vacuum chamber reaches $5 \times 10^{-4}$ Pa or less (low pressure of $5 \times 10^{-4}$ Pa or less). Heating during vacuum drawing is preferred. With the aid of heating, the removal of moisture can be more reliably carried out as well as a vacuum drawing time can be reduced. If the degree of vacuum in the vacuum chamber exceeds $5 \times 10^{-4}$ Pa (pressure higher than $5 \times 10^{-4}$ Pa) during heating, the removal of moisture absorbed by the apparatus, the film-forming substrate, the sputtering target, or the like is readily insufficient. Consequently, the density of a film to be obtained is reduced, resulting in adverse effect on the electrical conductivity and the moisture resistance of the film. It is preferable that the exhaust system of the sputtering apparatus for use has a trap or getter for removing moisture.

After vacuum drawing, the film formation of a transparent conductive film is performed. The degree of vacuum during film formation is preferably in the range of $1 \times 10^{-2}$ to $2 \times 10^{0}$ Pa. If the degree of vacuum is less than $1 \times 10^{-2}$ Pa (pressure lower than $1 \times 10^{-2}$ Pa), the discharge stability during film formation is reduced, whereas if the degree of vacuum exceeds $1 \times 10^{0}$ Pa (pressure higher than $1 \times 10^{0}$ Pa), it is difficult to raise a voltage to be applied to the sputtering target. The degree of vacuum during film formation is particularly preferably in the range of 0.1 to 1 Pa.

The DC power source output during film formation is preferably in the range of 1 W/cm$^2$ to 10 W/cm$^2$. If the output exceeds 10 W/cm$^2$, the density of a film to be obtained is reduced, and it becomes difficult to obtain a transparent conductive film having high moisture resistance.

The DC power source output during film formation is more preferably in the range of 3 to 8 W/cm$^2$.

The voltage during film formation is preferably in the range of 100 to 400 V.

As the atmospheric gas during film formation, only argon gas (Ar gas) may be generally used so as to obtain a film having sufficient high transparency. A mixed gas of argon gas (Ar gas) and oxygen gas ($O_2$ gas) may also be used. The mixing ratio of Ar gas and $O_2$ gas may differ depending on the oxidation states of a sputtering target for usage, and the degree of vacuum and the output during film formation. When the volume concentration of $O_2$ gas relative to the total volume of an atmospheric gas exceeds 5%, the electrical conductivity of the film to be obtained is readily decreased. Thus, the volume concentration of $O_2$ gas relative to the total volume of an atmospheric gas during film formation is preferably 5% or less and is more preferably 3% or less.

The purity of atmospheric gas is preferably 99.991% or more, is more preferably 99.995% or more, and is particularly preferably 99.999% or more.

The substrate temperature during film formation may be appropriately selected within the range of 50 °C to the heat resistance temperature of the film-forming substrate. However, if the substrate temperature exceeds 200 °C, such temperature exceeds the heat resistance temperature of many resin substrates, and thus, the type of a substrate employable is strictly limited. If the substrate temperature is less than 50 °C, the density of a film to be obtained is reduced, and it becomes difficult to obtain a transparent conductive film having high moisture resistance. Thus, the substrate temperature during film formation is preferably in the range of 50 to 200 °C, is more preferably in the range of 80 to 200 °C, and is particularly preferably in the range of 100 to 200 °C.

A film-forming substrate may be appropriately selected depending on the application or the like of the intended transparent conductive film. Examples of a film-forming substrate include a glass substrate, a metal substrate, a heat-resistant resin substrate, a solar cell (one in the midst of manufacturing process), or the like, but are not particularly limited thereto. Specific examples of the glass substrate include a glass substrate composed of a soda-lime glass, a lead glass, a borosilicate glass, a silicate glass, an alkali-free glass, or the like, and these glass substrates on which $SiO_2$, $SiO_x$ ($1 \le x < 2$), $TiO_x$ ($1 \le x \le 2$), or the like is coated.

Specific examples of the metal substrate include a metal foil such as a stainless steel foil, a copper foil, an aluminum foil, or the like, a metal plate equivalent to these metallic foils, a metal sheet equivalent to these metallic foils, and the like.

Specific examples of the heat-resistant resin substrate include a formed product, a film, a sheet, or the like composed of a resin having a heat distortion temperature of approximately 70 °C or more such as a polyester resin such as polyethylene terephthalate, a polycarbonate resin, a polyallylate resin, a polyethersulfone resin, an amorphous polyolefin resin, a polystyrene resin, an acryl resin, or the like, and a formed product, a film, a sheet, or the like in which a gas barrier layer, a solvent resistance layer, a hard coat layer, or the like is formed on the surface thereof.

As described above, in the method for manufacturing an oxide sputtering target for a transparent conductive film according to the present embodiment, a powder mixture in which Al oxide, Mg oxide, Ga oxide, and Zn oxide are mixed together according to the aforementioned content ratios is subjected to pressure sintering. Consequently, the diffusion of Al into Zn oxide is promoted by the presence of Ga serving as a diffusion aid, and thus, an Al-Mg-Ga-Zn-based oxide sputtering target may be obtained wherein the electrical conductivity thereof is further improved. More specifically, an Al-Mg-Ga-Zn-based oxide sputtering target having the volume resistance of $1 \times 10^{-2}$ $\Omega \cdot$cm or less may be obtained.

Also, in the present embodiment, the addition of Ga and pressure sintering such as hot pressing or the like are carried out. Thus, a target having a high density and a high electrical conductivity suitable for sputtering may be obtained by the synergistic effect of the simultaneous utilization of the sintering promotion effect and densification temperature reduction effect both obtained by the addition of Ga, and the sintering promotion effect and the densification temperature reduction effect both obtained by pressure sintering such as hot pressing or the like.

[Examples]

Based on the present embodiment, a description will be given of Examples of actually produced sputtering targets for a transparent conductive film.

Preparation of the sputtering targets of the present invention:

As raw material powders, $Al_2O_3$ raw material powder having a purity of 99.9% or higher and an average particle diameter of 0.4 μm, MgO raw material powder having a purity of 99.9% or higher and an average particle diameter of 1 μm, $Ga_2O_3$ raw material powder having a purity of 99.9% or higher and an average particle diameter of 0.3 μm, and ZnO raw material powder having a purity of 99.9% or higher and an average particle diameter of 0.4 μm were weighed and blended together so as to obtain a predetermined composition as shown in Table 1. The resulting powder mixture was introduced into a polyethylene pot, was subjected to ball milling using a φ 3 (diameter φ: 3 mm) $ZrO_2$ ball, and was pulverized into particles having an average particle diameter of 0.4 μm or less (a solvent used for ball milling is ethanol, and no addition of dispersant and other aids) to thereby obtain a slurry having a target average particle diameter. The resulting slurry was dried under ambient air, and then was dried in vacuo at a temperature of 80 °C for 5 hours to thereby obtain a dried powder mixture. The resulting powder mixture was filled into a graphite mold and was subjected to vacuum hot-pressing under the condition of a predetermined sintering temperature, a predetermined sintering time, and 350 kgf/cm$^2$ as shown in Table 1 to thereby produce a sintered compact having the size of φ 165 × 9 mmt (165 mm in diameter × 9 mm in thickness). Then, the resulting sintered compact was machined to thereby produce a sputtering target for forming a transparent conductive film of the present invention having the size of φ 152.4 × 6 T (152.4 mm in diameter × 6 mm in thickness) as shown in Table 1 (hereinafter referred to as "Example 1 to Example 5").

Preparation of sputtering targets in Conventional Examples:

By mixing raw material powders as shown in Table 1, a powder mixture not containing $Ga_2O_3$ component was

prepared. A sputtering target for forming a transparent conductive film in Conventional Examples having the size of φ 152.4 × 6 T (152.4 mm in diameter × 6 mm in thickness) as shown in Table 1 (hereinafter referred to as "Conventional Example 1 and Conventional Example 2") was produced in the same manner as that in Examples 1 to 5.

Preparation of sputtering targets in Comparative Examples:

By mixing raw material powders as shown in Table 1, a sputtering target for forming a transparent conductive film in Comparative Examples having the size of φ 152.4 × 6 T (152.4 mm in diameter × 6 mm in thickness) as shown in Table 1 (hereinafter referred to as "Comparative Examples 1 to 4") was produced in the same manner as that in Examples 1 to 5.

In Comparative Example 2, a powder mixture was dried in vacuo at a temperature of 80 °C for 5 hours, was filled into a rubber mold, and was subjected to cold isostatic pressing molding at 2000 kgf/cm$^2$ for 2 min. After sintering under ambient air at a temperature of 1450 °C for 5 hours, the resulting sintered compact was machined to thereby produce a sputtering target having the size of φ 152.4 × 6 T (152.4 mm in diameter × 6 mm in thickness).

For each of the sputtering targets in Examples 1 to 5, Conventional Examples 1 and 2, and Comparative Examples 1 to 4, the theoretical density ratio, the specific resistance, and the content of metal elements were calculated.

The theoretical density ratio was calculated by measuring the weight and the dimension of each sputtering target.

The specific resistance was measured by a four probe type resistance meter "Loresta" manufactured by Mitsubishi Gas Chemical Company, Inc.

The content of metal elements was calculated by the quantitative measurement of the melted fragment cut from each sputtering target using an ICP method.

The results are shown in Table 1.

[Table 1]

| | CHARGED MATERIAL wt% | | | | SINTERING TEMPERATURE °C | SINTERING TIME (h) | THEORETICAL DENSITY RATIO OF SINTERED COMPACT | SPECIFIC RESISTANCE OF SINTERED COMPACT AFTER MACHINING mΩ·cm | CONTENT RATIO OF METAL COMPONENT ELEMENT RELATIVE TO THE TOTAL CONTENTS OF METAL COMPONENT ELEMENTS IN SINTERED COMPACT (ATOMIC %) | | | |
|---|---|---|---|---|---|---|---|---|---|---|---|---|
| | Al2O3 | MgO | Ga2O3 | ZnO | | | | | Al | Mg | Ga | Zn |
| EXAMPLE 1 | 5 | 10 | 0.1 | 84.9 | 1100 | 2 | 95 | 6 | 7.0 | 17.8 | 0.076 | REMAINDER |
| EXAMPLE 2 | 3 | 5 | 0.07 | 91.93 | 1100 | 2 | 92 | 2 | 4.5 | 9.4 | 0.056 | REMAINDER |
| EXAMPLE 3 | 2 | 5 | 0.05 | 92.95 | 1050 | 3 | 97 | 3 | 3.0 | 9.5 | 0.041 | REMAINDER |
| EXAMPLE 4 | 0.5 | 7 | 0.07 | 92.43 | 1050 | 3 | 95 | 8 | 0.7 | 13.2 | 0.057 | REMAINDER |
| EXAMPLE 5 | 3 | 12 | 0.02 | 84.96 | 1150 | 2 | 98 | 8 | 4.3 | 21.5 | 0.015 | REMAINDER |
| | | | | | | | | | | | | REMAINDER |
| CONVENTIONAL EXAMPLE1 | 3 | 10 | 0 | 87 | 1100 | 2 | 93 | 5 | 4.3 | 18.0 | 0 | REMAINDER |
| CONVENTIONAL EXAMPLE2 | 5 | 5 | 0 | 90 | 1100 | 2 | 95 | 6 | 7.4 | 9.3 | 0 | REMAINDER |
| COMPARATIVE EXAMPLE1 | 3 | 10 | 0.01 | 86.99 | 1100 | 2 | 93 | 6 | 4.3 | 18.0 | 0.008 | REMAINDER |
| COMPARATIVE EXAMPLE2 | 3 | 5 | 0.3 | 91.7 | 1100 | 3 | 98 | 4 | 4.4 | 9.4 | 0.2 | REMAINDER |
| COMPARATIVE EXAMPLE3 | 0 | 10 | 0.5 | 89.5 | 1100 | 3 | 97 | 4000 | 0 | 18.3 | 0.391 | REMAINDER |
| COMPARATIVE EXAMPLE4 | 3 | 15 | 0.05 | 81.95 | 1100 | 3 | 95 | 200 | 4.0 | 26.0 | 0.050 | REMAINDER |

Preparation of transparent conductive films:

Each of the sputtering targets in Examples 1 to 5, Conventional Examples 1 and 2, and Comparative Examples 1 to 4 was bonded to a copper backing plate using In and was sputtered in a sputtering apparatus to thereby form a transparent conductive film as shown in Table 2.

Although the sputtering conditions are shown in Table 2, the degree of vacuum reached during sputtering was in the range of 0.5 to 6 $\times$ $10^{-4}$ Pa, the pressure of Ar gas during sputtering was in the range of 0.4 to 0.67 Pa, and the substrate temperature was within the range of room temperature to 250 °C.

The power source used for sputtering was Direct Current (DC) power source RPG-50 manufactured by MKS Instruments, Inc.

The substrate used was an alkali-free glass (1737# manufactured by Corning Incorporated).

For each of the obtained transparent conductive films, the film thickness was determined by a stylus probe method [Instrument used: DEKTAK 3030 (manufactured by Sloan corporation)], and the content of the metal component elements was determined by Inductively Coupled Plasma Emission Spectroscopy [Instrument used: SPS-1500VR (manufactured by SEIKO INSTRUMENTS INC.)].

The film thickness and the content of metal component elements of each transparent conductive film are shown in Table 2.

[Table 2]

| SPUTTERING CONDITIONS AND FILM PARAMETERS | | | | | | | | | | |
|---|---|---|---|---|---|---|---|---|---|---|
| | SPUTTERING CONDITIONS | | | | | | CONTENT RATIO OF METAL COMPONENT ELEMENT IN FILM (ATOMIC %) | | | |
| | DEGREE OF REACHED × 10-4 PA | Ar GAS PRESSURE PA | SUBSTRATE TEMPERATURE °C | INPUT POWER $W/cm^2$ | DC SPU TERING ENABLED/DISABLED | FILM THICKNESS nm | Al | Mg | Ga | Zn |
| EXAMPLE 1 | 1 | 0.4 | 100 | 5 | ENABLED | 100 | 7.0 | 18 | 0.08 | REMAINDER |
| EXAMPLE 2 | 6 | 0.7 | 200 | 8 | ENABLED | 200 | 4.5 | 9.2 | 0.06 | REMAINDER |
| EXAMPLE 3 | 4 | 0.6 | 100 | 8 | ENABLED | 150 | 3.0 | 9.5 | 0.04 | REMAINDER |
| EXAMPLE 4 | 4 | 0.67 | 250 | 3 | ENABLED | 200 | 0.75 | 14 | 0.06 | REMAINDER |
| EXAMPLE 5 | 0.5 | 0.67 | ROOM TEMPERATURE | 8 | ENABLED | 300 | 4.2 | 20 | 0.015 | REMAINDER |
| | | | | | | | | | | |
| CONVENTIONAL EXAMPLE 1 | 6 | 0.67 | 200 | 5 | ENABLED | 100 | 4.4 | 19 | 0 | REMAINDER |
| CONVENTIONAL EXAMPLE 2 | 0.5 | 0.4 | ROOM TEMPERATURE | 8 | ENABLED | 200 | 7.5 | 9.3 | 0 | REMAINDER |
| COMPARATIVE EXAMPLE 1 | 0.5 | 0.67 | 200 | 8 | ENABLED | 100 | 4.5 | 18.0 | 0.008 | REMAINDER |
| COMPARATIVE EXAMPLE 2 | 4 | 0.67 | 100 | 8 | ENABLED | 200 | 4.5 | 9.1 | 0.24 | REMAINDER |
| COMPARATIVE EXAMPLE 3 | 6 | 0.67 | 100 | 8(RF) | DISABLED | 200 | 0 | 18 | 0.39 | REMAINDER |
| COMPARATIVE EXAMPLE 4 | 6 | 0.7 | 200 | 8(RF) | FREQUENT OCCURRENCE OF ABNORMAL DISCHARGE | 200 | 4.0 | 25.5 | 0.05 | REMAINDER |

Furthermore, the film characteristics (specific resistance, light transmissivity, band gap, and moisture resistance of the film) of transparent conductive films in Examples 1 to 5, Conventional Examples 1 and 2, and Comparative Examples 1 to 4 were examined.

The specific resistance of each film was measured by a four probe type resistance meter "Loresta" manufactured by Mitsubishi Gas Chemical Company, Inc.

The light transmissivity of each film was measured by spectroscopy [Instrument used: U-3210 (manufactured by Hitachi, Ltd.)].

The band gap of each film was calculated by a spectral curve.

For evaluating the moisture resistance of each film, the specific resistance of each film, which was left alone for 1000 hours under a high-temperature high-humidity atmospheric environment at a temperature of 80 °C and the R.H of 85% in accordance with moisture resistance test criteria equivalent to solar cell evaluation, was measured by a four probe type resistance meter "Loresta" manufactured by Mitsubishi Gas Chemical Company, Inc.

The characteristic values are shown in Table 3.

[Table 3]

| | FILM CHARACTERISTICS | | | |
|---|---|---|---|---|
| | PRIOR TO HIGH-TEMPERATURE HIGH-HUMIDITY TEST | | | POST HIGH-TEMPERATURE HIGH-HUMIDITY TEST |
| | FILM SPECIFIC RESISTANCE mΩ · cm | FILM TRANSMITTANCE % | FILM BAND GAP eV | FILM SPECIFIC RESISTANCE mΩ · cm |
| EXAMPLE 1 | 8 | 90 | 3.99 | 14 |
| EXAMPLE 2 | 1 | 91 | 3.60 | 3 |
| EXAMPLE 3 | 3 | 92 | 3.62 | 6 |
| EXAMPLE 4 | 9 | 94 | 3.75 | 21 |
| EXAMPLE 5 | 7 | 92 | 3.97 | 16 |
| | | | | |
| CONVENTIONAL EXAMPLE1 | 2 | 92 | 3.97 | ∞ |
| CONVENTIONAL EXAMPLE2 | 8 | 90 | 3.62 | ∞ |
| COMPARATIVE EXAMPLE1 | 2 | 92 | 3.97 | 400 |
| COMPARATIVE EXAMPLE2 | 40 | 86 | 3.61 | 40 |
| COMPARATIVE _ EX AMPLE3 | 2000 | 93 | 3.97 | 3000 |
| COMPARATIVE EXAMPLE4 | 200 | 93 | 4.00 | 1000 |

As can be seen from the comparison of the results for the film characteristics shown in Tables 1 to 3, there was no large difference in respect of the light transmissivity and the band gap of each of the transparent conductive films in Examples 1 to 5, Conventional Examples 1 and 2, and Comparative Examples 1 to 4. However, in Conventional Examples 1 and 2 in which Ga was not contained as a metal component in a film, the film specific resistance after the high-temperature high-humidity test was extremely increased, resulting in a significant deterioration in film characteristics.

In Comparative Example 1 in which the Ga content was less than 0.015 atomic % which is the lower limit value defined by the present invention, the film specific resistance after the high-temperature high-humidity test was as high as 4000 (mΩ·cm). Thus, it can be seen that the deterioration in film characteristics occurred.

In Comparative Example 2, 0.24 atomic % of Ga was contained as a component in a film, and thus, the initial resistance was high. Thus, the film in Comparative Example 2 was clearly deteriorated as a transparent conductive film more than a film containing 0.1 atomic % or less of Ga, however, exhibited less deterioration in the film specific resistance due to high-temperature and high-humidity because of the high content of Ga.

In Comparative Example 3, Al was not contained as a metal component in a film, but the Ga content exceeded 0.085 atomic % which is the upper limit value defined by the present invention. Consequently, the electrical resistance of the film formed was significantly high, and thus, it can be seen that the film in Comparative Example 3 exhibited insufficient electrical conductivity as a transparent conductive film.

In Comparative Example 4, 25.5 atomic % of Mg is contained as a component in a film, and thus, the conductivity of the target decreased, resulting in a difficulty in sputtering by DC only. The electrical conductivity of the film decreased with an increase in the amount of Mg. Consequently, the film in Comparative Example 4 exhibited insufficient characteristics as a transparent conductive film, and the deterioration in the electrical conductivity of the film after the high-temperature high-humidity test was drastic.

Next, a description will be given of other Examples of the produced oxide sputtering targets for a transparent conductive film of the present invention.

As raw material powders in Examples of the present invention, $Al_2O_3$ raw material powder having a purity of 99.9% or higher and an average particle diameter of 0.4 μm, MgO raw material powder having a purity of 99.9% or higher and an average particle diameter of 1 μm, $Ga_2O_3$ raw material powder having a purity of 99.9% or higher and an average particle diameter of 0.3 μm, and ZnO raw material powder having a purity of 99.9% or higher and an average particle diameter of 0.4 μm were weighed and blended together so as to obtain a predetermined composition as shown in Table 4. The resulting powder mixture was introduced into a polyethylene pot, was subjected to ball milling using a zirconia ball having a diameter of 3 mm, and was mixed and pulverized into particles (a solvent used for ball milling is ethanol, and no addition of dispersant and other aids) to thereby obtain a slurry having a target average particle diameter (0.3 μm). The resulting slurry was dried in vacuo at a temperature of 80 °C for 5 hours to thereby obtain a dried powder mixture. The resulting dried powder mixture was granulated by sieving through a 5.00 μm mesh opening so as to have an average particle diameter of 500 μm or less.

[Table 4]

| EXAMPLE | % BY WEIGHT OF EACH OF RAW MATERIAI POWDER DURING MIXTING | | | | ATOMIC % OF EACH METAL ELEMENT RELATIVE TO TOTAL METAL ELEMENTS IN TARGET | | | | HP | | TARGET | |
|---|---|---|---|---|---|---|---|---|---|---|---|---|
| | Al2O3 | MgO | Ga2O3 | ZnO | Al | Mg | Ga | Zn | TEMPERATURE | PRESSURE | DENSITY | ELECTRICAL RESISTANCE $\Omega \cdot cm$ |
| 6 | 3 | 10 | 0.03 | 86.97 | 4.28 | 18.03 | 0.02 | 77.67 | 1250 | 200 | 98% | $5 \times 10^{-3}$ |
| 7 | 2 | 5 | 0.1 | 92.90 | 3.00 | 9.60 | 0.08 | 87.41 | 1100 | 500 | 97% | $0.5 \times 10^{-3}$ |
| COMPARATIVE EXAMPLE | | | | | | | | | | | | |
| 5 | 0.2 | 5 | 0.1 | 94.70 | 0.30 | 9.60 | 0.08 | 90.02 | 1250 | 300 | 99% | $>10^{7}$ |
| 6 | 8 | 5 | 0.1 | 86.90 | 11.63 | 9.19 | 0.08 | 79.10 | 1250 | 200 | 93% | $25 \times 10^{-1}$ |
| 7 | 2 | 20 | 0.15 | 77.85 | 2.63 | 33.22 | 0.11 | 64.04 | 1300 | 350 | 99% | $12 \times 10^{-3}$ |
| 8 | 0.5 | 10 | 0.25 | 89.25 | 0.72 | 18.28 | 0.20 | 80.80 | 1200 | 300 | 98% | $5 \times 10^{-3}$ |
| 0 | 0.5 | 10 | 0 | 89.50 | 0.72 | 18.28 | 0.00 | 81.00 | 1200 | 300 | 93% | $40 \times 10^{-3}$ |
| CONVENTIONAL EXAMPLE | | | | | | | | | OXYGEN ORDINARY-PRESSURE SINTERING | | | |
| 3 | 3 | 10 | 0 | 87.00 | 4.20 | 10.03 | 0.00 | 77.69 | 1400 | NO PRESSURIZING | 99% | $>10^{7}$ |
| 4 | 3 | 17 | 0 | 80.00 | 4.02 | 28.82 | 0.00 | 67.16 | 1400 | NO PRESSURIZING | 99% | $>10^{7}$ |
| 5 | 2 | 3 | 0 | 95.00 | 3.06 | 5.81 | 0.00 | 91.13 | 1400 | NO PRESSURIZING | 99% | $>10^{7}$ |
| 6 | 0.5 | 10 | 0 | 89.50 | 0.72 | 18.28 | 0.00 | 81.00 | 1400 | NO PRESSURIZING | 98% | $>10^{7}$ |

The resulting dried powder mixture was filled into a graphite mold and was subjected to vacuum hot-pressing under the condition of the heating ratio of 10 °C/min, the maximum temperature in the range of 1000 to 1350 °C, and the pressure of 150 to 500 kgf/cm$^2$ to thereby produce a sintered compact having the size of 165 mm in diameter × 9 mm in thickness. Then, the resulting sintered compact was machined to thereby produce a sputtering target for forming a transparent conductive film (Examples 6 and 7) having the size of 152.4 mm in diameter × 6 mm in thickness.

Furthermore, as Comparative Examples, the targets (Comparative Examples 5 to 9) were produced in a similar manner using the composition in which the amounts of Al, Ga, and Mg added exceeded the range.

For comparison, the sputtering targets for forming a transparent conductive film (Conventional Examples 3 to 6 shown in Table 4) were produced in a manner similar to that disclosed in Patent Document 1.

Firstly, as raw material powders in Conventional Examples, $Al_2O_3$ raw material powder having a purity of 99.9% or higher and an average particle diameter of 0.4 μm, MgO raw material powder having a purity of 99.9% or higher and an average particle diameter of 1 μm, and ZnO raw material powder having a purity of 99.9% or higher and an average particle diameter of 0.4 μm were weighed so as to obtain a predetermined composition. Among the weighted raw material powders, $Al_2O_3$ and ZnO were mixed together, and the resulting powder mixture was introduced into a polyethylene pot, was subjected to ball milling for 8 hours using a zirconia ball having a diameter of 3 mm, and was mixed and pulverized into particles (a solvent used for ball milling is ethanol, and no addition of dispersant and other aids). Then, the resulting powder mixture was dried in vacuo in a vacuum drier at a temperature of 80 °C for 5 hours to thereby obtain a dried powder mixture. The resulting dried powder mixture was granulated by sieving through a 500 μm mesh opening so as to have an average particle diameter of 500 μm or less.

Next, the granulated powder mixture was calcinated under ambient air at a temperature of 1000 °C for 3 hours to thereby produce a calcined powder of $Al_2O_3$ and ZnO. To the calcined powder MgO raw material powder described above was added, and the resulting mixture was subjected to ball milling for 8 hours using a zirconia ball having a diameter of 3 mm, and was mixed and pulverized into particles (a solvent used for ball milling is ethanol, and no addition of dispersant and other aids). Then, the resulting powder mixture was dried in vacuo in a vacuum drier at a temperature of 80 °C for 5 hours to thereby obtain a dried powder mixture. The resulting dried powder mixture was granulated by sieving through a 500 μm mesh opening so as to have an average particle diameter of 500 μm or less.

Next, the granulated powder mixture was calcinated at a temperature of 1000 °C for 3 hours to thereby produce a calcined powder of $Al_2O_3$, ZnO, and MgO. The resulting powder mixture was subjected to ball milling for 24 hours using a zirconia ball having a diameter of 3 mm, and was mixed and pulverized into particles (a solvent used for ball milling is ethanol, and no addition of dispersant and other aids). Then, the calcined powder was dried in vacuo in a vacuum drier at a temperature of 80 °C for 5 hours to thereby obtain a dried powder mixture. The resulting dried powder mixture was granulated by sieving through a 500 μm mesh opening so as to have an average particle diameter of 500 μm or less.

Next, the granulated and calcined powder was pressure-molded using a metal mold press under the pressure of 500 kgf/cm$^2$, and was further sintered in an oxygen atmosphere at a temperature of 1400 °C for 5 hours to thereby produce a sintered compact. Then, the sintered compact was machined to thereby produce a sputtering target for forming a transparent conductive film having the same size as that in Examples of the present invention (Conventional Examples 3 to 6).

The theoretical density ratio of each of the sintered compacts produced by the manufacturing method in Conventional Examples, Examples of the present invention, and Comparative Examples was calculated and described in Table 4. The theoretical density ratio was calculated as follows:

$$\text{Theoretical density ratio \%} = (\text{volume density of sintered compact}/\text{theoretical density}) \times 100$$

Theoretical density = 1/ (% by weight of $Al_2O_3$ in raw material/density of $Al_2O_3$ + % by weight of $Ga_2O_3$ in raw material/density of $Ga_2O_3$ + % by weight of MgO in raw material/density of MgO + % by weight of ZnO in raw material/density of ZnO)

Furthermore, the specific resistance of the target was measured by a resistance meter "Loresta" manufactured by Mitsubishi Chemical corporation. As a result of measurement, the specific resistance of the sintered compacts in Conventional Examples 3 to 6 was too high to measure. Thus, the sintered compacts in Conventional Examples 3 to 6 had no electrical conductivity. In contrast, the sintered compacts in Examples 6 and 7 of the present invention exhibited good electrical conductivity of $7 \times 10^{-3}\Omega\cdot cm$ at maximum. Although Patent Document 1 discloses the fact that the bulk resistance in the range of 30 to 60 $\times 10^{-3}\ \Omega\cdot cm$ was obtained, the sintered compacts in Conventional Examples 3 to 6 could not exhibit electrical conductivity as a result of additional tests as described above. Even if the sintered compact in Conventional Example exhibits the specific resistance as disclosed in Patent Document 1, it can be seen that the sintered compacts in Examples of the present invention exhibit the specific resistance less than one order of magnitude as compared with those in Conventional Example.

As described above, in the manufacturing method in Examples of the present invention, it is contemplated that the diffusion of Al into Zn oxide is promoted by the presence of Ga serving as a diffusion aid and $Al^{3+}$ is solid-solved in $Zn^{2+}$, and thus, an Al-Mg-Ga-Zn-based oxide sputtering target may be obtained wherein the electrical conductivity thereof is further improved.

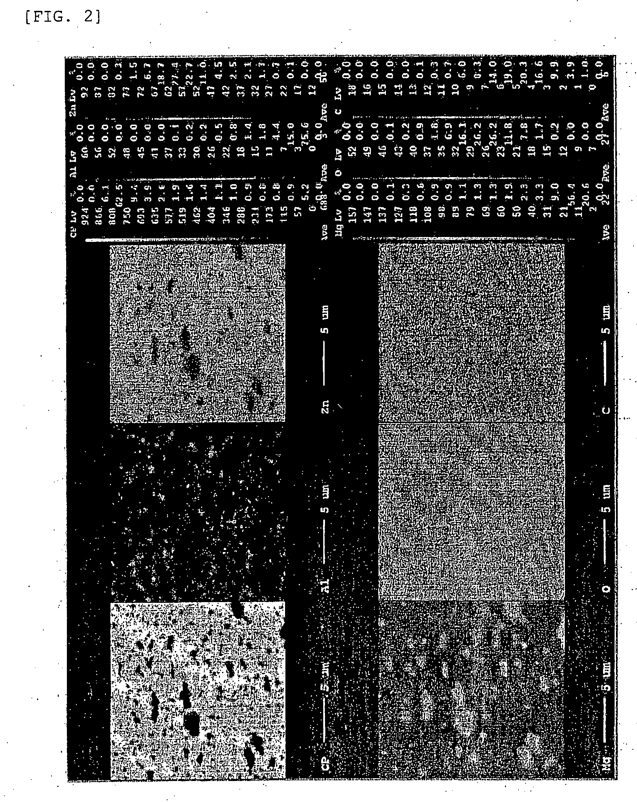

FIG. 2 is an image illustrating an element distribution map measured by EPMA (Electron Probe Micro Analyzer) for a sintered compact produced by the manufacturing method in Examples of the present invention. It can be seen from the EPMA image that Al is dispersed in the structure.

Next, the targets in Conventional Examples, Examples of the present invention, and Comparative Examples were evaluated using a DC sputtering method. More specifically, whether or not sputtering can be made for each target was tested using a DC sputtering power source (RPG-50 manufactured by MKS).

The sputtering gas during sputtering was Ar only, the gas pressure during sputtering was 0.6 Pa, the distance between the substrate and the target was 70 mm, and the substrate temperature was room temperature. The power applied to each target (diameter φ 152.4 mm) was 1200 W. Furthermore, a continuous discharging was performed for 30 min at 1200 W, the number of times of abnormal discharge during continuous sputtering for 30 min was measured using an abnormal discharge counter provided in the power source, and the presence/absence of cracks in each target due to sputtering was visually determined. Then, a film having the thickness of 300 nm was formed on a glass substrate (1737# manufactured by Corning Incorporated), and the electrical resistance of the film was measured using a four probe measurement method (a resistance meter "Loresta" manufactured by Mitsubishi Chemical corporation). The results are shown in Table 5.

[Table 5]

| | | THE NUMBER OF TIMES ABNORMAL DISCHARGE OCCURED DURING 30 MIN CONTINUOUS SPUTTERING | | FILM CONDUCTIVITY |
|---|---|---|---|---|
| EXAMPLE | DC SPUTTERING ENABLED/DISABLED | | PRESENCE/ABSENCE OF CRACKS IN TARGET | ELECTRICAL RESISTANCE Ω·cm |
| 6 | ENABLED | o | NONE. | $3 \times 10^{-3}$ |
| 7 | ENABLED | 0 | NONE | $0.8 \times 10^{-3}$ |
| COMPARATIVE EXAMPLE | | | | |
| 5 | DISABLED | - | - | - |
| 6 | ENABLED | 350 | NONE | $1\ 0 \times 10^{-3}$ |
| 7 | ENABLED | 25 | NONE | $27 \times 10^{-3}$ |
| 8 | ENABLED | 10000 | CRACKED | - |
| 9 | ENABLED | 1400 | CRACKED | - |
| | | | | |
| CONVENTIONAL EXAMPLE | | | | |
| 3 | DISABLED | | | |
| 4 | DISABLED | | | |
| 5 | DISABLED | | | |
| 6 | DISABLED | | | |

From experimental results shown in Table 5, the targets in Conventional Examples 3 to 6 exhibited high electrical resistance, and thus, DC sputtering could not be performed. On the other hand, the added amount of Al was small in Comparative Example 5, the electrical resistance of the target was high, and thus, DC sputtering could not be performed as well. The added amount of Al was large in Comparative Example 6, resulting in a reduction in sinterability of the target. Consequently, the density of the target was low, the number of times of abnormal discharge during sputtering was many, and the electrical resistance of the film was also high. The Mg content was high in Comparative Example 7, and thus, the electrical resistance of the target was high, resulting in frequent occurrence of abnormal discharge during sputtering. Furthermore, it can be seen that the electrical resistance of the film was high.

Since the added amount of Ga was excessively large in Comparative Example 8, the crystal grains of the target were grown during sintering, resulting in a reduction in the bulk strength of the target. In addition, cracks occurred in the target during DC continuous sputtering, resulting in a significant increase in the number of times abnormal discharge occurred. Since there was no addition of Ga in Comparative Example 9, the sintering promotion effect of Ga was not obtained. Thus, the density of the target was low, resulting in the occurrence of cracks during sputtering.

From the results of comparison described above, in the manufacturing method in Examples of the present invention, the diffusion of Al into Zn oxide is promoted by the presence of Ga serving as a diffusion aid, and $Al^{3+}$ is solid-solved in $Zn^{2+}$, and thus, an Al-Mg-Ga-Zn-based oxide sputtering target may be obtained wherein the electrical conductivity thereof is further improved. For the Al-Mg-Ga-Zn-based oxide puttering target, the number of times abnormal discharge occurred during sputtering for a long time was significantly low, resulting in an excellent in sputtering crack resistance.

The technical scope of the present invention is not limited to the aforementioned embodiments and Examples, but the present invention may be modified in various ways without departing from the scope or teaching of the present invention.

[Industrial Applicability]

As described above, the Al-Mg-Ga-Zn-based oxide transparent conductive film of the present invention can be readily formed by means of DC sputtering or pulse DC sputtering and is far more excellent in excellent moisture resistance. Thus, for example, the film of the present invention may be used for a first transparent conductive film, a second transparent conductive film, or an intermediate layer film for a solar cell. In this case, the deterioration in film characteristics can be suppressed in use for a long period of time, and the reduction in power generation efficiency can also be suppressed, and thus, the film of the present invention can be expected to achieve practical application for the future dissemination of solar cells.

Also, since the method for manufacturing an oxide sputtering target for a transparent conductive film of the present invention can produce a sputtering target for a transparent conductive film having a high electrical conductivity, for example, the method of the present invention is expected as a method for manufacturing a sputtering target for forming a transparent conductive film for a solar cell, an organic EL, or the like which can be subjected to stable DC sputtering with high film-forming rate.

[Reference Numerals]

1: glass substrate (light transmitting substrate), 2: backside opaque electrode (backside metal electrode layer), 3: power generation layer, 4: first transparent conductive film, 5: top cell layer (second photoelectric conversion layer), 6: intermediate layer, 7: bottom cell layer (first photoelectric conversion layer), 8: second transparent conductive film (transparent layer, upper transparent layer), 9: photoelectric conversion cell

## Claims

1. A transparent conductive film composed of an Al-Mg-Ga-Zn-based oxide **characterized by** the content ratios of metal component elements of said oxide are 0.7-7% Al, 9.2-25% Mg, 0.015-0.085% Ga, and the remainder is Zn, by atomic ratio.

2. A solar cell (9) comprising:

   a photoelectric conversion layer (5,7) that generates an electromotive force by means of light irradiation; and positive and negative electrodes (2,4) that are electrically connected to the photoelectric conversion layer, wherein at least one of the positive and negative electrodes comprises the transparent conductive film according to claim 1.

3. An oxide sputtering target for forming the transparent conductive film according to claim 1 composed of an Al-Mg-Ga-Zn-based oxide **characterized by** the content ratios of metal component elements of said oxide are 0.7-7% Al, 9.2-25% Mg, 0.015-0.085% Ga, and the remainder is Zn, by atomic ratio.

4. The oxide sputtering target according to claim 3, wherein a volume resistance is $1 \times 10^{-2}$ Ω·cm or less.

5. A method for manufacturing the oxide sputtering target according to claim 4, comprising the steps of:

producing a powder mixture by blending an Al oxide, an Mg oxide, a Ga oxide, and a Zn oxide such that the content ratios of metal component elements are 0.7-7% Al, 9.2-25% Mg, 0.015-0.085% Ga, and the remainder is Zn and by milling and mixing the resulting oxides; and
heating and sintering the powder mixture while applying a pressure under vacuum or inert gas atmosphere.

## Patentansprüche

1. Transparente leitfähige Folie, zusammengesetzt aus einem Oxid auf Al-Mg-Ga-Zn-Basis, **dadurch gekennzeichnet, dass** die Gehaltanteile von Metallkomponentenelementen des Oxids im Atomverhältnis 0,7 bis 7 % Al, 9,2 bis 25 % Mg, 0,015 bis 0,085 % Ga betragen und der Rest Zn ist.

2. Solarzelle (9), Folgendes umfassend:

eine fotoelektrische Konversionsschicht (5, 7), die mittels Lichteinstrahlung eine elektromotorische Kraft erzeugt, und
positive und negative Elektroden (2, 4), die mit der fotoelektrischen Konversionsschicht elektrisch verbunden sind,
wobei mindestens eine der positiven und negativen Elektroden die transparente leitfähige Folie nach Anspruch 1 umfasst.

3. Oxid-Sputter-Target zum Bilden der transparenten leitfähigen Folie nach Anspruch 1, zusammengesetzt aus einem Oxid auf AL-Mg-Ga-Zn-Basis, **dadurch gekennzeichnet, dass** die Gehaltanteile von Metallkomponentenelementen des Oxids im Atomverhältnis 0,7 bis 7 % Al, 9,2 bis 25 % Mg, 0,015 bis 0,085 % Ga betragen und der Rest Zn ist.

4. Oxid-Sputter-Target nach Anspruch 3, wobei ein Durchgangswiderstand 1 x $10^{-2}$ Ω·cm oder weniger beträgt.

5. Verfahren zur Herstellung des Oxid-Sputter-Targets nach Anspruch 4, folgende Schritte umfassend:

Herstellen einer Pulvermischung durch Vermischen eines Al-Oxids, eines Mg-Oxids, eines Ga-Oxids und eines Zn-Oxids derart, dass die Gehaltanteile von Metallkomponentenelementen 0,7 bis 7 % Al, 9,2 bis 25 % Mg, 0,015 bis 0,085 % Ga betragen und der Rest Zn ist, sowie durch Mahlen und Mischen der entstandenen Oxide, und
Erwärmen und Sintern der Pulvermischung, während ein Unterdruck oder eine Inertgasumgebung an-/vorliegt.

## Revendications

1. Film conducteur transparent composé d'un oxyde à base d'Al-Mg-Ga-Zn **caractérisé en ce que** les rapports de teneur en éléments composants métalliques dudit oxyde sont 0,7 à 7% d'Al, 9,2 à 25% de Mg, 0,015 à 0,085% de Ga, et le reste étant du Zn, en rapport atomique.

2. Cellule solaire (9) comprenant :

une couche de conversion photoélectrique (5, 7) qui génère une force électromotrice au moyen d'une irradiation de lumière ; et
des électrodes positive et négative (2, 4) qui sont reliées électriquement à la couche de conversion photoélectrique,
dans laquelle au moins l'une des électrodes positive et négative comprend le film conducteur transparent selon la revendication 1.

**3.** Cible de pulvérisation cathodique d'oxyde pour la formation du film conducteur transparent selon la revendication 1 composé d'un oxyde à base d'Al-Mg-Ga-Zn **caractérisée en ce que** les rapports de teneur en éléments composants métalliques dudit oxyde sont 0,7 à 7% d'Al, 9,2 à 25% de Mg, 0,015 à 0,085% de Ga, et le reste étant du Zn, en rapport atomique.

**4.** Cible de pulvérisation cathodique d'oxyde selon la revendication 3, dans laquelle une résistance transversale est inférieure ou égale à $1x10^{-2}$ Ω.cm.

**5.** Procédé pour la fabrication de la cible de pulvérisation cathodique d'oxyde selon la revendication 4, comprenant les étapes consistant :

à produire un mélange de poudre par mélange d'un oxyde d'Al, d'un oxyde de Mg, d'un oxyde de Ga, et d'un oxyde de Zn de sorte que les rapports de teneur en éléments composants métalliques soient 0,7 à 7% d'Al, 9,2 à 25% de Mg, 0,015 à 0,085% de Ga, le reste étant du Zn et par broyage et mélange des oxydes résultants ; et à chauffer et à fritter le mélange de poudre tout en appliquant une pression sous vide ou sous atmosphère de gaz inerte.

[FIG. 1]

2
8
9
7
3
6
5
4
1

[FIG. 2]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2025654 A1
- WO 2006129410 A


### Non-patent literature cited in the description


- *APPLIED PHYSICS LETTERS,* vol. 85 (8), 1374-1376